(19) Europäisches Patentamt
European Patent Office
Office européen des brevets

(11) EP 1 589 086 A1

(12) **EUROPEAN PATENT APPLICATION**
published in accordance with Art. 158(3) EPC

(43) Date of publication:
**26.10.2005 Bulletin 2005/43**

(21) Application number: **04705907.6**

(22) Date of filing: **28.01.2004**

(51) Int Cl.[7]: **C09J 7/02**, H01L 21/02

(86) International application number:
**PCT/JP2004/000757**

(87) International publication number:
**WO 2004/067666 (12.08.2004 Gazette 2004/33)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **31.01.2003 JP 2003023367**
**08.07.2003 JP 2003271782**

(71) Applicant: **TEIJIN LIMITED**
**Osaka-shi Osaka 541-0054 (JP)**

(72) Inventors:
- **YOSHITOMI, Takashi c/o Teijin Limited Iwakuni-shi, Yamaguchi 7400014 (JP)**
- **KOJIMA, Kazunori 7028021 (JP)**
- **NAKAMURA, Tsutomu c/o Teijin Limited Iwakuni-shi, Yamaguchi 7400014 (JP)**
- **ISHIWATA, Toyoaki c/o Teijin Limited Iwakuni-shi, Yamaguchi 7400014 (JP)**
- **SAWAKI, Toru c/o Teijin Limited Iwakuni-shi, Yamaguchi 7400014 (JP)**

(74) Representative: **Hallybone, Huw George**
**Carpmaels and Ransford,**
**43 Bloomsbury Square**
**London WC1A 2RA (GB)**

# (54) ADHESIVE SHEET AND LAYERED PRODUCT

(57) There are provided an adhesive sheet, exhibiting a specific peel strength and shear peel strength and being composed of a base material (A) comprising a fully aromatic polyimide film having a glass transition temperature of 200°C or above and a thermal adhesive layer (C) comprising a fully aromatic polyamide having a glass transition temperature of 200-500°C, as well as a laminate composed of the sheet and a process for its production. Also provided is a method of release after treatment of the laminate composed of the adhesive sheet, to obtain a laminate having the target to-be-treated layer.

EP 1 589 086 A1

## Description

### Technical Field

The present invention relates to an adhesive sheet and a laminate, and to a process for their production.

### Background Art

The fabrication steps for semiconductor devices of silicon, gallium, arsenic and the like are categorized into front end steps for element formation in the state of a large-diameter semiconductor wafer, and back end steps for separation of the wafer into individual element chips and finishing of the final product.

In the front end steps, methods of miniaturization and thinning of the semiconductor chips include, for example, element formation in the state of a large-diameter semiconductor wafer followed by backgrinding treatment for shaving of the semiconductor wafer to reduce the thickness of the semiconductor wafer itself in order to achieve a thinner overall chip. Such shaving of the semiconductor wafer requires the side of the semiconductor wafer opposite the shaving side to be adhesively anchored onto a support via an adhesive sheet. In addition, such thinning steps must be followed by processing during the various fabrication steps with the semiconductor wafer still adhesively anchored to the support, and consequently adhesive sheets having high heat resistance of 400°C and above, for example, have been desired to withstand such treatment.

In the back end steps, the semiconductor wafer is first subjected to dicing into chips, and then subsequently passed through a step of die bonding of the chip onto a lead frame.

During the process, the semiconductor wafer is diced, washed and dried with the adhesive sheet already attached, after which various steps are carried out, such as expanding of the adhesive sheet and release of the chip from the adhesive sheet (pick-up).

The adhesive sheet used in the process from semiconductor wafer dicing to pick-up must retain adequate adhesive strength on the chip from dicing to drying, and it preferably has a satisfactory release property so that the adhesive does not adhere to the chip during pick-up.

Numerous types of semiconductor wafer-attaching adhesive sheets have been proposed to satisfy the requirements for such back end steps.

For example, there have been proposed pressure-sensitive adhesive tapes comprising base materials and pressure-sensitive adhesive layers formed using compositions comprising (meth)acrylic acid ester copolymers, epoxy resins, photopolymerizing low molecular compounds, heat activating latent epoxy resin curing agents and photopolymerization initiators (see Japanese Unexamined Patent Publication HEI No. 2-32181), dicing films comprising polymer support films having surfaces with substantially no release layer and conductive adhesives, (see Japanese Examined Patent Publication HEI No. 3-34853), and methods wherein an adhesive layer for die bonding is provided on a heat foaming pressure-sensitive adhesive layer formed on a support base, where the adhesive layer and heat foaming pressure-sensitive adhesive layer are releasable by heating (see Japanese Unexamined Patent Publication HEI No. 3-268345).

Recent years have seen a marked increase in demand for high-density mounting for miniaturization and thinning of electronic devices. Semiconductor packages for the most part are surface mounting types suitable for high-density mounting, which have come into more common use in place of conventional pin insertion types. Such thin semiconductor packages are mounted by infrared reflow, vapor phase reflow or solder dipping, for direct soldering onto printed boards by surface mounting. However, a problem occurs when the package contains absorbed moisture, the gasification of which due to sudden heat during mounting results in generation of cracks. As a method for solving this problem, there has been proposed an adhesive sheet having a moisture absorption rate of 1.5 vol% and an elastic modulus of no greater than 10 MPa at 250°C (Japanese Unexamined Patent Publication No. 2002-256237).

However, conventional adhesive sheets have been associated with the following problems.

Conventional adhesive sheets have exhibited insufficient strength as supports when used with ultrathin semiconductor wafers, and the semiconductor wafers tend to fracture during the fabrication steps such as polishing of semiconductor wafers for thinning, or conveying, and this has constituted a problem in terms of yield.

It is possible to attach a laminate of a backing material made of an inorganic substance on an adhesive sheet onto the semiconductor wafer for strength reinforcement. In this case, the adhesive sheet must exhibit adequate holding strength in the polishing step carried out during the semiconductor wafer fabrication and adequate bonding in conveying steps, while the adhesive sheet must also be releasable without residue on the semiconductor wafer side, before the semiconductor wafer dicing step. From the standpoint of reutilization of the support as well, the adhesive sheet is preferably easy to release from the support at the final stage.

Furthermore, because of the high exposure temperatures of 400°C and above in the fabrication steps, it has been necessary to meet several requirements, including heat resistance to 400°C and above and the ability to withstand

soldering, as well as resistance to release of moisture or decomposition and low molecular substance generation at high temperatures.

## Disclosure of the Invention

It is an object of the invention to provide an adhesive sheet and laminate exhibiting heat resistance and appropriate bonding with adherends to permit their use in semiconductor device fabrication steps, as well as a property allowing their release after being supplied for the purpose. It is another object of the invention to provide a process for obtaining a laminate containing the intended to-be-treated layer, by releasing the laminate containing the adhesive sheet after treatment has been accomplished.

Specifically, the invention relates to an adhesive sheet composed of a base material (A) comprising a fully aromatic polyimide film and a thermal adhesive layer (C) comprising a fully aromatic polyamide having a glass transition temperature of 200-500°C, the adhesive sheet being characterized in that, when the thermal adhesive layer (C) and base material (A) are laminated in that order on a silicon wafer adherend, either or both of the following conditions (a) and (b) are satisfied.

(a) A peel strength of 0.1-300 N/m at the interface between the thermal adhesive layer (C) and silicon wafer upon thermocompression bonding for 15 minutes at 300°C, 5.0-6.0 MPa.

(b) A shear peel adhesive strength of 1-1000 $N/cm^2$ at the interface between the thermal adhesive layer (C) and silicon wafer upon thermocompression bonding for 2 minutes at 300°C, 5.0-6.0 MPa.

The invention also relates to a laminate (I) composed of the aforementioned adhesive sheet attached to an inorganic material. The invention further relates to a laminate (II) prepared by laminating an organic protective layer (E) and a to-be-treated layer (D) on the aforementioned laminate (I), and to a production process therefor.

The invention still further relates to a laminate (I') which is a laminate composed of a base material (A) comprising a fully aromatic polyimide film with a glass transition temperature of 200°C or above and an inorganic material (B), characterized in that when the base material (A) and a silicon wafer adherend are laminated, the base material (A) exhibits the following property:

(a') A peel strength of 0.1-100 N/m at the interface between the base material (A) and silicon wafer upon thermocompression bonding for 15 minutes at 370°C, 5.0-6.0 MPa.

The invention still further relates to a laminate (II') prepared by laminating an organic protective layer (E) and a to-be-treated layer (D) on the aforementioned laminate (I'), and to a production process therefor.

The invention still further relates to a process for production of a laminate characterized in that, after obtaining the aforementioned laminate, the exposed surface of layer D is subjected to thinning treatment to produce layer D' and obtain a laminate (III) comprising layer D', layer E, layer A, layer C and layer B, after which the interface between layer E and layer A is released to obtain a laminate (IV) composed of layer D' and layer E.

## Detailed Description of the Preferred Embodiment

### (Adhesive sheet)

The adhesive sheet according to the invention is either of two types, one type consisting only of the base material (A) comprising a fully aromatic polyimide film, and the other composed of a base material (A) comprising a fully aromatic polyimide film and a thermal adhesive layer (C) composed of a fully aromatic polyamide having a glass transition temperature of 200-500°C.

The adhesive sheet of the invention preferably has a Young's modulus in the range of 1.0-30 GPa. If the Young's modulus is less than 1.0 GPa the handling property is impaired, while if it is greater than 30 GPa, the difference in thermal expansion coefficients makes it difficult for the adhesive sheet itself to alleviate the residual stress generated during cooling after thermocompression, thus often notably lowering the adhesive strength. The preferred range is 2.0-25 GPa. The range is more preferably 3.0-20 GPa and even more preferably 10.0-20 GPa. Here, the Young's modulus is the value obtained by measurement using a 50 mm x 10 mm sample at a pull speed of 5 mm/min, and calculating the strength at an elongation of 100% from the initial gradient of the elongation-strength curve for the obtained data.

The adhesive sheet preferably has a linear thermal expansion coefficient in the range of -10 ppm/°C to +45 ppm/°C. According to a preferred mode of the invention, the linear thermal expansion coefficient of the inorganic material used as the adherend is in the range of -5 ppm/°C to +35 ppm/°C. Thus, the linear expansion coefficient of the

adhesive sheet is preferably a value reasonably close to the linear thermal expansion coefficient of the adherend composed of the inorganic material. If the linear expansion coefficient of the adhesive sheet is a value smaller than -10 ppm/°C or larger than +35 ppm/°C, the adhesive force after thermocompression, and for example, after cooling to room temperature, may be insufficient. The preferred range is from -5 ppm/°C to +35 ppm/°C. Hence, the absolute value of the difference in linear thermal expansion coefficients of the adhesive sheet and the adherend composed of the inorganic material is preferably in the range of 0.01 ppm/°C to 30 ppm/°C. If the absolute value of the difference in linear thermal expansion coefficients of the adhesive sheet and adherend is greater than 30 ppm/°C, residual stress will be produced by differences in temperature, thereby lowering the adhesive strength. If it is less than 0.01 ppm/°C, the release property after attachment is reduced, and it is usually difficult to peel the semiconductor device product from the support after it has passed through the semiconductor device fabrication steps. This phenomenon is seen more markedly with thin semiconductor devices. Because of the thinness of the semiconductor, the strength of the semiconductor chip itself is lower and the semiconductor chip tends to easily break when peeled off. More preferably, the absolute value of the difference in the linear thermal expansion coefficients of the adhesive sheet and the adherend composed of the inorganic material is in the range of 1 ppm/°C to 20 ppm/°C. Here, the linear thermal expansion coefficient is the value determined by calculation from the change in sample length between 100°C and 200°C, with heating and cooling in a range of 50-250°C at a temperature variation rate of 10°C/min.

The adhesive sheet may be any form such as a tape, label or the like. The thickness of the adhesive sheet is preferably in the range of 1-2000 μm. At less than 1 μm, precise bonding cannot be achieved with the adherend composed of the inorganic material, and the contact surface of the contact bonding apparatus will need to have a precise flatness and smoothness, as a lack of precise flatness and smoothness will tend to result in bonding spots. At greater than 2000 μm, heat transfer will be impeded during attachment with the adherend composed of the inorganic material, and therefore more time will be required for temperature transfer, thereby reducing productivity.

(Adhesive sheet composed of base material (A) and thermal adhesive layer (C))

An adhesive sheet composed of a base material (A) and thermal adhesive layer (C) will now be explained.

The invention provides an adhesive sheet composed of a base material (A) comprising a fully aromatic polyimide film and a thermal adhesive layer (C) comprising a fully aromatic polyamide having a glass transition temperature of 200-500°C, the adhesive sheet being characterized in that, when the thermal adhesive layer (C) and base material (A) are laminated in that order on a silicon wafer adherend, either or both of the following conditions (a) and (b) are satisfied.

(a) A peel strength of 0.1-300 N/m at the interface between the thermal adhesive layer (C) and silicon wafer upon thermocompression bonding for 15 minutes at 300°C, 5.0-6.0 MPa.

(b) A shear peel adhesive strength of 1-1000 $N/cm^2$ at the interface between the thermal adhesive layer (C) and silicon wafer upon thermocompression bonding for 2 minutes at 300°C, 5.0-6.0 MPa.

If the peel strength is less than 0.1 N/m, it will not be possible to achieve adequate adhesive force for transit through the semiconductor device fabrication steps, and the semiconductor chip will tend to fall off from the board during the process.

However, a value of greater than 300 N/m for the bonding with the adherend in terms of peel strength is not preferred because it will be difficult to release the adhesive sheet when the silicon wafer is to be recovered for reuse. Thus, the peel strength of the adhesive sheet of the invention is preferably at least 1.0 N/m and no greater than 300 N/m, and more preferably at least 5 N/m and no greater than 200 N/m.

Here, the peel strength is the value obtained by preparing a 1 cm-wide sheet-like adhesive body thermocompression bonded with a silicon wafer adherend for 15 minutes at 300°C, 5.0-6.0 MPa, determining the average pull force (N) from a force-clamp travel distance curve across a peel length of at least 100 mm, subtracting the initial 25 mm, measured at a pull speed of about 300 mm/min at 25°C, and calculating the value per 1 m width (N/m). The surface roughness of the silicon wafer may be a degree of surface smoothness for silicon wafers used in ordinary semiconductor fabrication. For example, the surface roughness (Rt) of the silicon wafer may be about 0.02 μm according to actual measurement with a laser microscope.

If the shear peel adhesive strength is less than 1 $N/cm^2$, it is not possible to obtain sufficient adhesive force through the semiconductor device fabrication process, and the semiconductor chip will tend to fall from the board during the process.

However, a value of greater than 1000 $N/cm^2$ for the bonding with the adherend in terms of shear peel adhesive strength is not preferred because it will be difficult to release the adhesive sheet when the silicon wafer is to be recovered for reuse. Thus, the shear peel adhesive strength of the adhesive sheet of the invention is preferably at least 1 $N/cm^2$ and no greater than 1000 $N/cm^2$, and more preferably at least 5 $N/cm^2$ and no greater than 500 $N/cm^2$.

Here, the shear peel adhesive strength is the value obtained by coating an adhesive onto the exposed surface of a laminate composed of a 25 mm x 25 mm sheet-like adhesive body thermocompression bonded with a silicon wafer adherend for 2 minutes at 300°C, 5.0-6.0 MPa, bonding it to two 25 mm x 60 mm x 1 mm stainless steel plates sandwiching it on either side, and then using a method based on JIS K6851 for pulling at a pull speed of 10 mm/min at 25°C, determining the maximum value (N) for the peel stress, and calculating the shear peel adhesive strength per 1 $cm^2$ ($N/cm^2$).

By providing a thermal adhesive layer (C) comprising a fully aromatic polyamide it is possible to strengthen the bonding between the base material (A) comprising a fully aromatic polyimide film and the adherend (B) made of an inorganic material, while also allowing various constructions such as using the thermal adhesive layer only on one side of the base material and permitting variation in the adhesive force between each layer.

Moreover, by forming an adhesive sheet provided with a thermal adhesive layer (C) comprising a fully aromatic polyamide it is possible to achieve adequate adhesive force in a short time by thermocompression of each layer to obtain a laminate, and thus shorten the thermocompression holding time to between 0.1 second and 1 hour. In addition, since sufficient adhesive force can be obtained even at 180-500°C, it is possible to lower the temperature conditions compared to using an adhesive sheet composed of only a base material (A) comprising a fully aromatic polyimide film.

Furthermore, no excessive thermocompression treatment is necessary to provide the thermal adhesive layer (C), and therefore when a desired section is released after obtaining the laminate by thermocompression and performing various types of treatment, release treatment can be carried out rapidly, thereby increasing productivity.

(Base material)

The base material (A) as a constituent of the present invention comprises a fully aromatic polyimide film.

The fully aromatic polyimide used according to the invention is a polymer compound comprising an aromatic tetracarboxylic acid component and an aromatic diamine component.

As examples of aromatic tetracarboxylic acid components there may be mentioned pyromellitic acid, 1,2,3,4-benzenetetracarboxylic acid, 2,3,5,6-pyridinetetracarboxylic acid, 2,3,4,5-thiophenetetracarboxylic acid, 2,2',3,3'-benzophenonetetracarboxylic acid, 2,3',3,4'-benzophenonetetracarboxylic acid, 3,3',4,4'-benzophenonetetracarboxylic acid, 3,3',4,4'-biphenyltetracarboxylic acid, 2,2',3,3'-biphenyltetracarboxylic acid, 2,3,3',4'-biphenyltetracarboxylic acid, 3,3',4,4'-p-terphenyltetracarboxylic acid, 2,2',3,3'-p-terphenyltetracarboxylic acid, 2,3,3',4'-p-terphenyltetracarboxylic acid, 1,2,4,5-naphthalenetetracarboxylic acid, 1,2,5,6-naphthalenetetracarboxylic acid, 1,2,6,7-naphthalenetetracarboxylic acid, 1,4,5,8-naphthalenetetracarboxylic acid, 2,3,6,7-naphthalenetetracarboxylic acid, 2,3,6,7-anthracenetetracarboxylic acid, 1,2,5,6-anthracenetetracarboxylic acid, 1,2,6,7-phenanthrenetetracarboxylic acid, 1,2,7,8-phenanthrenetetracarboxylic acid, 1,2,9,10-phenanthrenetetracarboxylic acid, 3,4,9,10-perylenetetracarboxylic acid, 2,6-dichloronaphthalene-1,4,5,8-tetracarboxylic acid, 2,7-dichloronaphthalene-1,4,5,8-tetracarboxylic acid, 2,3,6,7-tetrachloronaphthalene-1,4,5,8-tetracarboxylic acid, 1,4,5,8-tetrachloronaphthalene-2,3,6,7-tetracarboxylic acid, bis(2,3-dicarboxyphenyl)ether, bis(3,4-dicarboxyphenyl)ether, bis(2,3-dicarboxyphenyl)methane, bis(3,4-dicarboxyphenyl)methane, bis(2,3-dicarboxyphenyl)sulfone, bis(3,4-dicarboxyphenyl)sulfone, 1,1-bis(2,3-dicarboxyphenyl)ethane, 1,1-bis(3,4-dicarboxyphenyl)ethane, 2,2-bis(2,3-dicarboxyphenyl)propane, 2,2-bis(3,4-dicarboxyphenyl) propane, 2,6-bis(3,4-dicarboxyphenoxy)pyridine, 1, 1, 1, 3, 3, 3-hexafluoro-2,2-bis(3, 4-dicarboxyphenyl)propane and bis(3,4-dicarboxyphenyl)dimethylsilane. Two or more of these aromatic tetracarboxylic acid components may also be used simultaneously in combination.

Examples of preferred aromatic tetracarboxylic acid components among those mentioned above include those comprising pyromellitic acid alone or comprising combinations of pyromellitic acid with other aromatic tetracarboxylic acids such as mentioned above. More specifically, pyromellitic dianhydride is preferably present at 50-100 mole percent based on the total tetracarboxylic acid component. With a pyromellitic dianhydride content of 50 mole percent or greater, it is possible to increase the imide group concentration in the total aromatic polyimide in order to achieve satisfactory bonding, as explained in detail below. Pyromellitic dianhydride is preferably present at 70-100 mole percent and more preferably at 90-100 mole percent, and most preferably pyromellitic dianhydride is used alone.

As examples of aromatic diamine components there may be mentioned p-phenylenediamine, m-phenylenediamine, 1,4-diaminonaphthalene, 1,5-diaminonaphthalene, 1,8-diaminonaphthalene, 2,6-diaminonaphthalene, 2,7-diaminonaphthalene, 2,6-diaminoanthracene, 2,7-diaminoanthracene, 1,8-diaminoanthracene, 2,4-diaminotoluene, 2,5-diamino(m-xylene), 2,5-diaminopyridine, 2,6-diaminopyridine, 3,5-diaminopyridine, 2,4-diaminotoluenebenzidine, 3,3'-diaminobiphenyl, 3,3'-dichlorobenzidine, 3,3'-dimethylbenzidine, 3,3'-dimethoxybenzidine, 2,2'-diaminobenzophenone, 4,4'-diaminobenzophenone, 3,3'-diaminodiphenylether, 4,4'-diaminodiphenylether, 3,4'-diaminodiphenylether, 3,3'-diaminodiphenylmethane, 4,4'-diaminodiphenylmethane, 4,4'-diaminodiphenylmethane, 3,4'-diaminodiphenylsulfone, 4,4'-diaminodiphenylsulfone, 3,3'-diaminodiphenylsulfide, 3,4'-diaminodiphenylsulfide, 4,4'-diaminodiphenylsulfide, 4,4'-diaminodiphenylthioether, 4,4'-diamino-3,3',5,5'-tetramethyldiphenylether, 4,4'-diamino-3,3',5,5'-tetraethyldiphenylether, 4,4'-diamino-3,3',5,5'-tetramethyldiphenylmethane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 2,6-bis(3-aminophenoxy)pyridine, 1,4-bis(3-aminophenylsulfonyl)benzene, 1,4-bis(4-aminophenylsulfonyl)benzene, 1,4-bis(3-aminophenylthioether)benzene, 1,4-bis(4-aminophenylthioether)benzene, 4,4'-bis(3-aminophenoxy)diphenylsulfone, 4,4'-bis(4-aminophenoxy)diphenylsulfone, bis(4-aminophenyl)aminebis(4-aminophenyl)-N-methylaminebis(4-aminophenyl)-N-phenylaminebis(4-aminophenyl)phosphineoxide, 1,1-bis(3-aminophenyl)ethane, 1,1-bis(4-aminophenyl)ethane, 2,2-bis(3-aminophenyl)propane, 2,2-bis(4-aminophenyl)propane, 2,2-bis(4-amino-3,5-dimethylphenyl)propane, 4,4'-bis(4-aminophenoxy)biphenyl, bis[4-(3-aminophenoxy)phenyl]sulfone, bis[4-(9-aminophenoxy)phenyl]sulfone, bis[4-(4-aminophenoxy)phenyl]ether, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy)phenyl]methane, 1,1-bis[4-(4-aminophenoxy)phenyl]ethane, 1,1-bis[3-methyl-4-(4-aminophenoxy)phenyl]ethane, 1,1-bis[3-chloro-4-(4-aminophenoxy)phenyl]ethane, 1,1-bis[3,5-dimethyl-4-(4-aminophenoxy)phenyl]ethane, 2,2-bis[4-(4-aminophenoxy)phenyl]propane,2,2-bis[3-methyl-4-(4-aminophenoxy)phenyl]propane,2,2-bis[3-chloro-4-(4-aminophenoxy)phenyl]propane, 2,2-bis[3,5-dimethyl-4-(4-aminophenoxy)phenyl]propane, 2,2-bis[4-(4-aminophenoxy)phenyl]butane, 2,2-bis[3-methyl-4-(4-aminophenoxy)phenyl]butane, 2,2-bis[3,5-dimethyl-4-(4-aminophenoxy)phenyl]butane, 2,2-bis[3,5-dibromo-4-(4-aminophenoxy)phenyl]butane, 1,1,1,3,3,3-hexafluoro-2,2-bis(4-aminophenyl)propane and 1,1,1,3,3,3-hexafluoro-2,2-bis[3-methyl-4-(4-aminophenoxy)phenyl]propane, as well as these compounds having the aromatic nucleus substituted with halogen atoms or alkyl groups. Two or more of these aromatic diamine components may also be used simultaneously in combination. Examples of preferred aromatic diamine components include p-phenylenediamine, m-phenylenediamine, 3,4'-diaminodiphenylether, 1,3-bis(3-aminophenoxy)benzene and 4,4'-diaminodiphenylether. Even more preferred as an aromatic diamine component is p-phenylenediamine at 30-100 mole percent based on the total diamine component. With p-phenylenediamine at 40 mole percent or greater, it is possible to increase the imide group concentration in the total aromatic polyimide in order to achieve satisfactory bonding, as explained in detail below. In this case, the other aromatic diamine component in addition to p-phenylenediamine is preferably 3,4'-diaminodiphenylether, 4,4'-diaminodiphenylether or 1,3-bis(3-aminophenoxy)benzene, with 3,4'-diaminodiphenylether being particularly preferred.

The fully aromatic polyimide preferably has an imide group density of between 5.0 eq./kg and 6.9 eq./kg. The imide group density is the value calculated according to the following formula (4).

Imide group density (eq./kg) = 2 x 1000/[molecular weight per constituent unit]

If the imide group density is less than 5.0 eq./kg, the density of polar groups in the fully aromatic polyimide is reduced, and this is undesirable because it results in weaker adhesive force with the adherend. Also, the upper limit for the imide group density is essentially about 6.9 eq./kg for chemical structural reasons. It is even more preferably between 5.5 eq./kg and 6.9 eq./kg.

Thus, as essentially preferred fully aromatic polyimides there may be mentioned fully aromatic polyimides which have a constituent unit represented by the following formula (1):

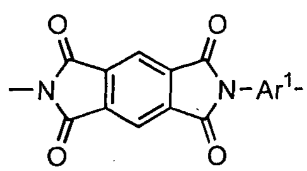

(1)

wherein $Ar^1$ is 1,4-phenylene which may optionally contain a non-reactive substituent,
or copolymerized fully aromatic polyimides which have 30-70 mole percent of a constituent unit represented by formula (1) above and 70-30 mole percent of a constituent unit represented by the following formula (2):

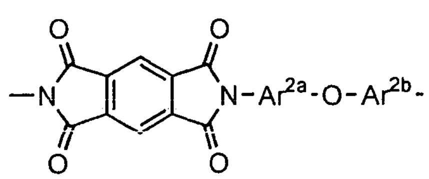

(2)

wherein $Ar^{2a}$ and $Ar^{2b}$ are each independently a C6-20 aromatic group optionally containing a non-reactive substituent.

When the base material (A) comprising a fully aromatic polyimide film is used alone as the adhesive sheet,

the copolymerized fully aromatic polyimides mentioned below are particularly preferred.

$Ar^1$ in formula (1) above is 1,4-phenylene which may optionally contain a non-reactive substituent. Examples of non-reactive substituents here include alkyl groups such as methyl, ethyl, propyl and cyclohexyl, aromatic groups such as phenyl and naphthyl, halogens such as chloro, fluoro, and bromo, alkoxy groups methoxy, ethoxy and phenoxy, and nitro groups and the like. Thus, as examples of $Ar^1$ there may be mentioned 2-chloro-1,4-phenylene, 2-bromo-1,4-phenylene, 2-methyl-1,4-phenylene, 2-ethyl-1,4-phenylene, 2-cyclohexyl-1,4-phenylene, 2-phenyl-1,4-phenylene, 2-nitro-1,4-phenylene, 2-methoxy-1,4-phenylene, 2,5-dichloro-1,4-phenylene, 2,6-dichloro-1,4-phenylene, 2,5-dibromo-1,4-phenylene, 2,6-dibromo-1,4-phenylene, 2,chloro-5-bromo-1,4-phenylene, 2,chloro-5-fluoro-1,4-phenylene, 2,5-dimethyl-1,4-phenylene, 2,6-dimethyl-1,4-phenylene, 2,5-dicyclohexyl-1,4-phenylene, 2,5-diphenyl-1,4-phenylene, 2,5-dinitro-1,4-phenylene, 2,5-dimethoxy-1,4-phenylene, 2,3,5-trichloro-1,4-phenylene, 2,3,5-trifluoro-1,4-phenylene, 2, 3, 5-trimethyl-1, 4-phenylene, 2,3,5,6-tetrachloro-1,4-phenylene, 2,3,5,6-tetrafluoro-1,4-phenylene, 2, 3, 5, 6-tetrabromo-1,4-phenylene, 2,3,5,6-tetramethyl-1,4-phenylene and 2,3,5,6-tetraethyl-1,4-phenylene. Particularly preferred among these is 1,4-phenylene. Also, $Ar^{2a}$ and $Ar^{2b}$ in formula (2) above are each independently a C6-20 aromatic group optionally containing a non-reactive substituent. Examples of non-reactive substituents in this case include the same non-reactive substituents mentioned for $Ar^1$ in formula (1). Thus, as examples of both $Ar^{2a}$ and $Ar^{2b}$ there may be mentioned 1,4-phenylene, 2-chloro-1,4-phenylene, 2-bromo-1,4-phenylene, 2-methyl-1,4-phenylene, 2-ethyl-1,4-phenylene, 2-cyclohexyl-1,4-phenylene, 2-phenyl-1,4-phenylene, 2-nitro-1,4-phenylene, 2-methoxy-1,4-phenylene, 2,5-dichloro-1,4-phenylene, 2,6-dichloro-1,4-phenylene, 2,5-dibromo-1,4-phenylene, 2,6-dibromo-1,4-phenylene, 2,chloro-5-bromo-1,4-phenylene, 2,chloro-5-fluoro-1,4-phenylene, 2,5-dimethyl-1,4-phenylene, 2,6-dimethyl-1,4-phenylene, 2,5-dicyclohexyl-1,4-phenylene, 2,5-diphenyl-1,4-phenylene, 2,5-dinitro-1,4-phenylene, 2,5-dimethoxy-1,4-phenylene, 2,3,5-trichloro-1,4-phenylene, 2,3,5-trifluoro-1,4-phenylene, 2,3,5-trimethyl-1,4-phenylene, 2,3,5,6-tetrachloro-1,4-phenylene, 2,3,5,6-tetrafluoro-1,4-phenylene, 2,3,5,6-tetrabromo-1,4-phenylene, 2,3,5,6-tetramethyl-1,4-phenylene, 2,3,5,6-tetraethyl-1,4-phenylene, 1,3-phenylene, 5-chloro-1,3-phenylene, 5-bromo-1,3-phenylene, 5-methyl-1,3-phenylene, 5-ethyl-1,3-phenylene, 5-cyclohexyl-1,3-phenylene, 5-phenyl-1,3-phenylene, 5-nitro-1,3-phenylene, 5-methoxy-1,3-phenylene, 2,5-dichloro-1,3-phenylene, 2,5-dibromo-1,3-phenylene, 2,5-dibromo-1,3-phenylene, 2,chloro-5-bromo-1,3-phenylene, 2,chloro-5-fluoro-1,3-phenylene, 2,5-dimethyl-2,3-phenylene, 2,5-dimethyl-1,3-phenylene, 2,5-dicyclohexyl-1,3-phenylene, 2,5-diphenyl-1,3-phenylene, 2,5-dinitro-1,3-phenylene, 2,5-dimethoxy-1,3-phenylene, 2,4,6-trichloro-1,3-phenylene, 2,4,6-trifluoro-1,3-phenylene, 2,4,6-trimethyl-1,3-phenylene, 1,6-biphenylene and 2,6-naphthylene. As particularly preferred examples among these there may be mentioned 1,4-phenylene and 1,3-phenylene.

The glass transition temperature of a fully aromatic polyimide according to the invention is 200°C or higher. A glass transition temperature of below 200°C is not preferred because the heat resistance will be inadequate for the preferred mode of the semiconductor device fabrication process. There are no particular restrictions on the upper limit, and this includes polyimides having no observable glass transition temperature at 5-00°C or above. The glass transition temperature is calculated from the value of the dynamic loss tangent tanδ which is calculated using the measured dynamic storage elastic modulus E' and dynamic loss elastic modulus E".

The method of producing the fully aromatic polyimide film is not particularly restricted and may be any conventional publicly known production method. For example, as the aromatic tetracarboxylic acid component starting material, all or a portion of the aromatic tetracarboxylic dianhydride or aromatic tetracarboxylic acid component may be a dicarboxylic halide-dicarboxylic acid alkyl ester derivative. An aromatic tetracarboxylic dianhydride is preferably used. The aromatic diamine component starting material may be an aromatic diamine or an amide acid-forming derivative of an aromatic diamine. For example, all or a portion of the amino groups of the aromatic diamine component may be trialkylsilylated, or amidated with an aliphatic acid such as acetic acid. Aromatic diamines are essentially preferred for use among these.

These starting materials may be obtained by, as one example, a method of conducting polymerization reaction in an organic polar solvent such as N-methyl-2-pyrrolidone, dimethylacetamide or dimethylimidazolidinone at a temperature of, for example, about -30°C to 120°C, to obtain an organic polar solvent solution of a polyamic acid or polyamic acid derivative as the precursor, casting the solution onto a support or the like and then drying at, for example, about 80-400°C and conducting heat treatment at a maximum temperature of 250-600°C for imidation reaction to obtain a fully aromatic polyimide film, or as another example, a method of using dicyclohexylcarbodiimide, or a combination of an aliphatic acid anhydride such as acetic anhydride with an organic nitrogen compound such as pyridine, for chemical cyclodehydration reaction to obtain a swelled gel film, and then stretching the gel film as desired, subjecting it to drying and heat treatment for a prescribed length of time to obtain a fully aromatic polyimide film (Japanese Unexamined Patent Publication No. 2002-179810). The method of stretching a gel film obtained by chemical dehydration reaction is a particularly preferred production method for this purpose since it allows free control of the thermal expansion coefficient by the stretching conditions.

(Thermal adhesive layer composed of a fully aromatic polyamide)

The fully aromatic polyamide to be used for the thermal adhesive layer (C) of the invention is preferably a fully aromatic polyamide which has a constituent unit represented by the following formula (3):

$$-\underset{\displaystyle O}{\overset{}{\underset{\|}{C}}}-Ar^{3a}-\underset{\displaystyle O}{\underset{\|}{C}}-\underset{\displaystyle H}{\underset{|}{N}}-Ar^{3b}-\underset{\displaystyle H}{\underset{|}{N}}- \qquad (3)$$

wherein $Ar^{3a}$ and $Ar^{3b}$ are each independently a C6-20 aromatic group optionally containing a non-reactive substituent, which consists of an aromatic dicarboxylic acid component containing $Ar^{3a}$ in formula (3) and an aromatic diamine component containing $Ar^{3b}$ in formula (3). $Ar^{3a}$ and $Ar^{3b}$ in formula (3) above are each independently a C6-20 aromatic group optionally containing a non-reactive substituent. Also, examples of non-reactive substituents optionally included in $Ar^{3a}$ and $Ar^{3b}$ in formula (3) include alkyl groups such as methyl, ethyl, propyl and cyclohexyl, aromatic groups such as phenyl and naphthyl, halogens such as chloro, fluoro, and bromo, and nitro, methoxy, ethoxy, phenoxy and the like. As aromatic dicarboxylic acid components for $Ar^{3a}$ there may be mentioned terephthalic acid, isophthalic acid, 1,4-dicarboxynaphthalene, 1,5-dicarboxynaphthalene, 1,8-dicarboxynaphthalene, 2,6-dicarboxynaphthalene, 2,7-dicarboxynaphthalene, 2,6-dicarboxyanthracene, 2,7-dicarboxyanthracene, 1,8-dicarboxyanthracene, 2,4-dicarboxytoluene, 2,5-dicarboxy(m-xylene), 3,3'-dicarboxybiphenyl, 2,2'-dicarboxybenzophenone, 4,4'-dicarboxybenzophenone, 3,3'-dicarboxydiphenylether, 4,4'-dicarboxydiphenylether, 3,4'-dicarboxydiphenylether, 3,3'-dicarboxydiphenylmethane, 4,4'-dicarboxydiphenylmethane, 4,4'-dicarboxydiphenylmethane, 3,4'-dicarboxydiphenylsulfone, 4,4'-dicarboxydiphenylsulfone, 3,3'-dicarboxydiphenylsulfide, 3,4'-dicarboxydiphenylsulfide, 4,4'-dicarboxydiphenylsulfide, 4,4'-dicarboxydiphenylthioether, 4,4'-dicarboxy3,3',5,5'-tetramethyldiphenylether, 4,4'-dicarboxy3,3',5,5'-tetraethyldiphenylether, 4,4'-dicarboxy3,3',5,5'-tetramethyldiphenylmethane, 1,3-bis(3-carboxyphenoxy)benzene, 1,3-bis(4-carboxyphenoxy)benzene, 1,4-bis(3-carboxyphenoxy)benzene, 1,4-bis(4-carboxyphenoxy)benzene, 2,6-bis(3-carboxyphenoxy)pyridine, 1,4-bis(3-carboxyphenylsulfonyl)benzene, 1,4-bis(4-carboxyphenylsulfonyl)benzene, 1,4-bis(3-carboxyphenylthioether)benzene, 1,4-bis(4-carboxyphenylthioether)benzene, 4,4'-bis(3-carboxyphenoxy)diphenylsulfone, 4,4'-bis(4-carboxyphenoxy)diphenylsulfone, bis(4-carboxyphenyl)aminebis(4-carboxyphenyl)-N-methylaminebis(4-carboxyphenyl)-N-phenylaminebis(4-carboxyphenyl)phosphineoxide, 1,1-bis(3-carboxyphenyl)ethane,1,1-bis(4-carboxyphenyl)ethane, 2,2-bis(3-carboxyphenyl)propane, 2,2-bis(4-carboxyphenyl)propane, 2,2-bis(4-carboxy3,5-dimethylphenyl)propane, 4,4'-bis(4-carboxyphenoxy)biphenyl, bis[4-(3-carboxyphenoxy)phenyl]sulfone, bis[4-(4-carboxyphenoxy)phenyl]sulfone, bis[4-(4-carboxyphenoxy)phenyl]ether, bis[4-(4-carboxyphenoxy)phenyl]methane, bis[3-methyl-4-(4-carboxyphenoxy)phenyl]methane, bis[3-chloro-4-(4-carboxyphenoxy)phenyl]methane, bis[3,5-dimethyl-4-(4-carboxyphenoxy)phenyl]methane, 1,1-bis[4-(4-carboxyphenoxy)phenyl]ethane, 1,1-bis[3-methyl-4-(4-carboxyphenoxy)phenyl]ethane, 1,1-bis[3-chloro-4-(4-carboxyphenoxy)phenyl]ethane, 1,1-bis[3,5-dimethyl-4-(4-carboxyphenoxy)phenyl]ethane, 2,2-bis[4-(4-carboxyphenoxy)phenyl]propane, 2,2-bis[3-methyl-4-(4-carboxyphenoxy)phenyl]propane, 2,2-bis[3-chloro-4-(4-carboxyphenoxy)phenyl]propane, 2,2-bis[3,5-dimethyl-4-(4-carboxyphenoxy)phenyl]propane, 2,2-bis[4-(4-carboxyphenoxy)phenyl]butane, 2,2-bis[3-methyl-4-(4-carboxyphenoxy)phenyl]butane, 2,2-bis[3,5-dimethyl-4-(4-carboxyphenoxy)phenyl]butane, 2,2-bis[3,5-dibromo-4-(4-carboxyphenoxy)phenyl]butane, 1,1,1,3,3,3-hexafluoro-2,2-bis(4-carboxyphenyl)propane and 1,1,1,3,3,3-hexafluoro-2,2-bis[3-methyl-4-(4-carboxyphenoxy)phenyl]propane, as well as these compounds having the aromatic nucleus substituted with halogen atoms or alkyl groups.

Two or more of these aromatic dicarboxylic acid components may also be used simultaneously in combination. Examples of preferred aromatic dicarboxylic acid components are terephthalic acid and isophthalic acid.

As examples of aromatic diamine components for $Ar^{3b}$ there may be mentioned p-phenylenediamine, m-phenylenediamine, 1,4-diaminonaphthalene, 1,5-diaminonaphthalene, 1,8-diaminonaphthalene, 2,6-diaminonaphthalene, 2,7-diaminonaphthalene, 2,6-diaminoanthracene, 2,7-diaminoanthracene, 1,8-diaminoanthracene, 2,4-diaminotoluene, 2,5-diamino(m-xylene), 2,5-diaminopyridine, 2,6-diaminopyridine, 3,5-diaminopyridine, 2,4-diaminotoluenebenzidine, 3,3'-diaminobiphenyl, 2,2'-diaminobenzophenone, 4,4'-diaminobenzophenone, 3,3'-diaminodiphenylether, 4,4'-diaminodiphenylether, 3,4'-diaminodiphenylether, 3,3'-diaminodiphenylmethane, 4,4'-diaminodiphenylmethane, 4,4'-diaminodiphenylmethane, 3,4'-diaminodiphenylsulfone, 4,4'-diaminodiphenylsulfone, 3,3'-diaminodiphenylsulfide, 3,4'-diaminodiphenylsulfide, 4,4'-diaminodiphenylsulfide, 4,4'-diaminodiphenylthioether, 4,4'-diamino-3,3',5,5'-tetramethyldiphenylether, 4,4'-diamino-3,3',5,5'-tetraethyldiphenylether, 4,4'-diamino-3,3',5,5'-tetramethyldiphenylmethane, 1,3-bis(3-aminophenoxy)benzene, 1,3-bis(4-aminophenoxy)benzene, 1,4-bis(3-aminophenoxy)benzene, 1,4-bis(4-aminophenoxy)benzene, 2,6-bis(3-aminophenoxy)pyridine, 1,4-bis(3-aminophenylsulfonyl)benzene, 1,4-bis(4-aminophenylsulfonyl)benzene, 1,4-bis(3-aminophenylthioether)benzene, 1,4-bis(4-aminophenylthioether)benzene, 4,4'-bis(3-aminophenoxy)diphenylsulfone, 4,4'-bis(4-aminophenoxy)diphenylsulfone, bis(4-aminophenyl)aminebis(4-aminophenyl)-N-methylaminebis(4-aminophenyl)-N-phenylaminebis(4-aminophenyl)phosphineoxide, 1,1-bis(3-aminophenyl)ethane, 1,1-bis(4-aminophenyl)ethane, 2,2-bis(3-aminophenyl)propane, 2,2-bis(4-aminophenyl)propane, 2,2-bis(4-amino-3,5-dimethylphenyl)propane, 4,4'-bis(4-aminophenoxy)biphenyl, bis[4-(3-aminophenoxy)phenyl]sulfone, bis[4-(4-aminophenoxy)phenyl]sulfone, bis[4-(4-aminophenoxy)phenyl]ether, bis[4-(4-aminophenoxy)phenyl]methane, bis[3-methyl-4-(4-aminophenoxy)phenyl]methane, bis[3-chloro-4-(4-aminophenoxy)phenyl]methane, bis[3,5-dimethyl-4-(4-aminophenoxy)phenyl]methane, 1,1-bis[4-(4-aminophenoxy)phenyl]ethane, 1,1-bis[3-methyl-4-(4-aminophenoxy)phenyl]ethane, 1,1-bis[3-chloro-4-(4-aminophenoxy)phenyl]ethane, 1,1-bis[3,5-dimethyl-4-(4-aminophenoxy)phenyl]ethane, 2,2-bis[4-(4-aminophenoxy)phenyl]propane, 2,2-bis[3-methyl-4-(4-aminophenoxy)phenyl]propane, 2,2-bis[3-chloro-4-(4-aminophenoxy)phenyl]propane, 2,2-bis[3,5-dimethyl-4-(4-aminophenoxy)phenyl]propane, 2,2-bis[4-(4-aminophenoxy)phenyl]butane, 2,2-bis[3-methyl-4-(4-aminophenoxy)phenyl]butane, 2,2-bis[3,5-dimethyl-4-(4-aminophenoxy)phenyl]butane, 2,2-bis[3,5-dibromo-4-(4-aminophenoxy)phenyl]butane, 1,1,1,3,3,3-hexafluoro-2,2-bis(4-aminophenyl)propane and 1,1,1,3,3,3-hexafluoro-2,2-bis[3-methyl-4-(4-aminophenoxy)phenyl]propane, as well as these compounds having the aromatic nucleus substituted with halogen atoms or alkyl groups. Two or more of these aromatic diamine components may also be used simultaneously in combination.

Examples of preferred aromatic diamine components include p-phenylenediamine, m-phenylenediamine, 3,4'-diaminodiphenylether, 4,4'-diaminodiphenylether and 1,3-bis(3-aminophenoxy)benzene. A more preferred aromatic diamine component is m-phenylenediamine. That is, the preferred fully aromatic polyamide is one wherein formula (3) above consists solely of the constituent unit represented by the following formula (3-1).

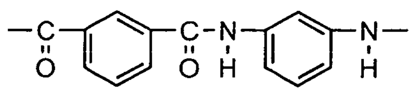

(3-1)

The process for producing the thermal adhesive layer (C) comprising a fully aromatic polyamide according to the invention is not particularly restricted, and any conventional publicly known production process may be employed. For example, the thermal adhesive layer (C) comprising a fully aromatic polyamide may be produced using a polymer solution after polymerization, or after isolation of the polymer and redissolution in a solvent. An organic polar solvent such as N-methyl-2-pyrrolidone, N,N-dimethylacetamide or N,N-dimethylformamide is preferred as the solvent, but strong acidic solvents such as concentrated sulfuric acid, concentrated nitric acid or polyphosphoric acid may also be used. Inorganic salts such as calcium chloride, magnesium chloride, lithium chloride, lithium nitrate or the like may also be added to the aromatic polyamide solution as dissolving aids if desired. The polymer concentration of the solution is preferably about 1-60 wt% and more preferably 3-40 wt%.

The polymer solution prepared in the manner described above is cast onto a base material (A) comprising a fully aromatic polyimide film or an adherend made of an inorganic material (B), and dried to drive off the solvent.

The casting method may be a method based on die extrusion, a method using an applicator, or a method using a coater.

There are no particular restrictions on the temperature of the polymer solution during casting, but it is preferably selected so that the viscosity of the polymer solution is between 30 and 20,000 Poise. The viscosity is more preferably 50-2000 Poise.

The drying method to drive off the solvent may be drying by hot air heating, vacuum heating, infrared heating or microwave heating, but heat drying with hot air is preferred. The drying temperature may be 30-400°C, preferably 40-350°C and more preferably 70-300°C.

The thickness of the thermal adhesive layer (C) comprising a fully aromatic polyamide according to the invention is preferably in the range of 0.1-1000 µm. At less than 0.1 µm, precise bonding cannot be achieved with the adherend (B) made of the inorganic material, and the contact surface of the contact bonding apparatus will need to have a precise flatness and smoothness, as a lack of precise flatness and smoothness will tend to result in bonding spots. At greater than 2000 µm, heat transfer will be impeded during attachment with the adherend (B) composed of the inorganic material, and therefore time will be required for temperature transfer, thereby reducing productivity.

The surface roughness of the thermal adhesive layer (C) comprising a fully aromatic polyamide according to the invention is not particularly restricted, but the value of the surface roughness (Rt) is preferably in the range of 0.01-100 µm. At less than 0.01 µm, the solvent will not penetrate as easily during impregnation of the solvent for release, thus often hampering release, and at greater than 100 µm, precise bonding cannot be achieved with the adherend (B) made of the inorganic material, often result in bonding spots.

(Laminate I' composed of adhesive sheet layer and inorganic material)

When the adhesive sheet composed of a base material (A) comprising a fully aromatic polyimide film, the laminate of the invention is a laminate (I') composed of a base material (A) comprising a fully aromatic polyimide film with a glass transition temperature of 200°C or above and an inorganic material (B), the laminate being characterized in that, when the base material (A) and a silicon wafer adherend are laminated, the base material (A) exhibits the following property:

(a') A peel strength of 0.1-100 N/m at the interface between the base material (A) and silicon wafer upon thermocompression bonding for 15 minutes at 370°C, 5.0-6.0 MPa.

With a peel strength of less than 0.1 N/m, it will not be possible to achieve adequate adhesive force for transit through the semiconductor device fabrication steps, and the semiconductor chip will tend to fall off from the board during the process.
Here, the peel strength is the value obtained by preparing a 1 cm-wide sheet-like adhesive body thermocompression bonded with a silicon wafer adherend for 15 minutes at 370°C, 5.0-6.0 MPa, determining the average pull force (N) from a force-clamp travel distance curve across a peel length of at least 100 mm, subtracting the initial 25 mm, measured at a pull speed of about 300 mm/min at 25°C, and calculating the value per 1 m width (N/m).
Here, the base material (A) is preferably a fully aromatic polyimide which has a constituent unit represented by the following formula (1):

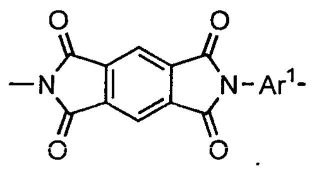

(1)

wherein $Ar^1$ is 1,4-phenylene which may optionally contain a non-reactive substituent.
Preferred for the base material (A) are fully aromatic polyimides which have 30-70 mole percent of a constituent unit represented by formula (1) above and 70-30 mole percent of a constituent unit represented by the following formula (2):

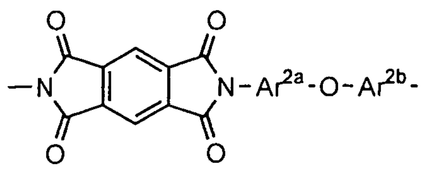

(2)

wherein $Ar^{2a}$ and $Ar^{2b}$ are each independently a C6-20 aromatic group optionally containing a non-reactive substituent.
Also, the base material (A) preferably comprises a fully aromatic polyimide having an imide group density (eq./kg) of between 5.5 eq./kg and 6.9 eq./kg, where the imide group density is calculated according to the following formula (4).
Imide group density (eq./kg) = 2 x 1000/[molecular weight per constituent unit]
The base material (A) comprising a fully aromatic polyimide film and the inorganic material (B) may be thermocompression bonded at a temperature of 180-600°C and a pressure of 0.001-1000 MPa for a period from 0.1 second to 48 hours, to obtain a laminate (I').
The conditions for bonding including temperature, pressure and time may be controlled as desired depending on the materials and combinations in the adhesive sheet and adherend used. The temperature for the thermocompression is in the range of 180-600°C, preferably in the range of 180-550°C and more preferably in the range of 180-500°C. The pressure for the thermocompression is in the range of 0.001-1000 MPa and preferably in the range of 0.01-100 MPa, in terms of the average pressure applied overall between the adhesive sheet and adherend. If the pressure is less than 0.001 MPa it will not be possible to achieve adequate bonding, while if the pressure is higher than 100 MPa, the adherend may experience damage.
The thermocompression holding time is in the range of 0.1 second to 48 hours, because if it is shorter than

0.1 second the adhesive force is inadequate, making it difficult to obtain a laminate with stabilized adhesive force. A time of longer than 48 hours will lower productivity. The thermocompression holding time is more preferably in a range from 1 second to 24 hours.

After the temperature has been increased during thermocompression and the prescribed pressure has been applied for the prescribed period of time for bonding, pressurization may be continued for a fixed time at room temperature for, cooling, or alternatively, after increasing the temperature and applying the prescribed pressure for the prescribed period of time for bonding, the temperature may be maintained for a fixed time with the pressure removed.

(Laminate I composed of adhesive sheet layer and inorganic material)

When the adhesive sheet composed of a base material (A) comprising a fully aromatic polyimide film and a thermal adhesive layer (C) comprising a fully aromatic polyamide having a glass transition temperature of 200-500°C, the laminate of the invention is a laminate (I) having an inorganic material (B) further laminated on the thermal adhesive layer (C) of the adhesive sheet, and therefore being composed of a base material (A) comprising a fully aromatic polyimide film, the thermal adhesive layer (C) and the inorganic material (B) laminated in that order.

The base material (A) comprising a fully aromatic polyimide film may be thermocompression bonded with the inorganic material (B), via the thermal adhesive layer (C) comprising a fully aromatic polyamide having a glass transition temperature of 200-500°C, at a temperature of 180-600°C and a pressure of 0.001-1000 MPa for a period from 0.1 second to 1 hour, to obtain the laminate (I).

The conditions for bonding including temperature, pressure and time may be controlled as desired depending on the materials and combinations in the adhesive sheet and adherend used. The temperature for the thermocompression is in the range of 180-600°C, preferably in the range of 180-550°C and more preferably in the range of 180-500°C. The pressure for the thermocompression is in the range of 0.001-1000 MPa and preferably in the range of 0.01-100 MPa, in terms of the average pressure applied overall between the adhesive sheet and adherend. If the pressure is less than 0.001 MPa it will not be possible to achieve adequate bonding, while if the pressure is higher than 100 MPa, the adherend may experience damage.

The thermocompression holding time is in the range of 0.1 second to 1 hour since thermocompression can be accomplished in a short time by provision of the thermal adhesive layer. If the time is shorter than 0.1 second the adhesive force is inadequate, making it difficult to obtain a laminate with stabilized adhesive force. The thermocompression holding time is more preferably in a range from 1 second to 30 minutes.

After the temperature has been increased during thermocompression and the prescribed pressure has been applied for the prescribed period of time for bonding, pressurization may be continued for a fixed time at room temperature for cooling, or alternatively, after increasing the temperature and applying the prescribed pressure for the prescribed period of time for bonding, the temperature may be maintained for a fixed time with the pressure removed.

(Inorganic material)

The inorganic material (B) according to the invention is one comprising at least 60 vol% of an inorganic compound. As examples of inorganic compounds there may be mentioned metals such as aluminum, iron, silicon, germanium and carbon, barium titanate, potassium titanate, nitrides such as titanium nitride, aluminum nitride and boron nitride, zirconium oxide, aluminum oxide, ceramics such as Cerasin by Mitsubishi Gas & Chemical Co., or glass, but semiconductor metals such as silicon and germanium are preferred, and silicon wafers are more preferred. These inorganic materials and inorganic material adherends may be in the form of crosses, meshes, inorganic sintered bodies, porous bodies, panels, sheets, films or the like, but porous bodies, panels and sheets are preferred. This therefore includes inorganic material adherends such as, for example, sheets made of carbon/epoxy composites produced from prepregs, or composites of sintered porous ceramics with epoxy resins.

The thickness of the inorganic material of the adherend is not particularly restricted but in most cases is preferably in the range of 1-2000 μm. At less than 1 μm, greater precision of the contact bonding apparatus will be required for bonding with the adhesive sheet, often making it difficult to accomplish regular, uniform bonding with the bonding surface. In addition, the resulting mechanical strength will not be sufficient for contact bonding, and therefore breakage will often occur during contact bonding. At greater than 2000 μm, heat transfer will be impeded during attachment with the adhesive sheet, and therefore time will be required for temperature transfer, thereby reducing productivity.

(Laminated bodies II, II' moreover comprising to-be-treated layer (D) and organic protective layer (E))

The invention also provides a laminate (II) comprising a to-be-treated layer (D), an organic protective layer (E), a base material (A) comprising a fully aromatic polyimide film, a thermal adhesive layer (C) and an inorganic

material (B), laminated in that order.

The invention further provides a laminate (II') composed of a to-be-treated layer (D), an organic protective layer (E), a base material (A) comprising a fully aromatic polyimide film having a glass transition temperature of 200°C or above and an inorganic material (B), laminated in that order.

The to-be-treated layer (D) is not particularly restricted so long as it can be bonded with the organic protective layer (E) described below by some method, but a preferred application according to the invention is for a semiconductor board subjected to circuit part formation steps including introduction of impurities. The inorganic material

(B) in this case is preferably a holding substrate.

The organic protective layer (E) is used for the purpose of protecting the to-be-treated layer (D). When the to-be-treated layer (D) is a semiconductor board subjected to circuit part formation steps including introduction of impurities, it is preferred to use a polyimide, fluorinated polyimide, polyorganohydridosilane, polysiloxane, polysiloxane-modified polyimide, polyphenylene, polybenzyl, polyaryl ether or the like, and more preferably a polysiloxane-modified polyimide.

The laminating method for the laminate is not particularly restricted, but the adhesive sheet and the adherend may be laminated at room temperature, with heat and pressure as necessary. As laminating methods there may be mentioned press bonding using a hot press machine or a vacuum press machine, and bonding with rollers.

For example, in the case of press bonding using a hot press machine, a protective sheet made of a metal such as stainless steel, iron, titanium, aluminum or copper, or an alloy thereof, a film made of a heat resistant polymer such as a fully aromatic polyimide and/or fully aromatic polyamide, and/or a resin in the form of fibers or the like made of such a heat resistant polymer, may be sandwiched between the top plate of the hot press machine and the adhesive sheet and adherend, at a thickness which does not inhibit heat transfer, as a buffering material so that the pressure reaches throughout the entire bonding surface.

The conditions for bonding including temperature, pressure and time may be controlled as desired depending on the materials or combinations in the adhesive sheet and adherend used for bonding. A suitable temperature for the bonding is in the range of 180-600°C, preferably in the range of 180-550°C and more preferably in the range of 180-500°C. The pressure for the bonding is in the range of 0.001-1000 MPa and preferably in the range of 0.01-100 MPa, in terms of the average pressure applied overall between the adhesive sheet and adherend. If the pressure is less than 0.001 MPa it is not possible to achieve adequate bonding, while if the pressure is higher than 100 MPa, the adherend may suffer damage.

The holding time for bonding is preferably in the range of 0.1 second to 48 hours. If it is shorter than 0.1 second, the adhesive force is inadequate, making it difficult to obtain a laminate with stabilized adhesive force. A time of longer than 48 hours will lower productivity. The holding time for bonding is more preferably in a range from 1 second to 24 hours. Thermal bonding can be accomplished in a short time by provision of the thermal adhesive layer.

After the temperature has been increased during bonding and the prescribed pressure has been applied for the prescribed period of time for bonding, pressurization may be continued for a fixed time at room temperature for cooling, or alternatively, after increasing the temperature and applying the prescribed pressure for the prescribed period of time for bonding, the temperature may be maintained for a fixed time with the pressure removed.

(Process for production of laminate IV)

The invention further provides a process for production of a laminate (IV) characterized in that, after a to-be-treated layer (D), an organic protective layer (E), a base material (A) comprising a fully aromatic polyimide film having a glass transition temperature of 200°C or above and an inorganic material (B) are laminated and thermocompression bonded in that order, the exposed surface of layer D is subjected to thinning treatment to produce layer D' and obtain a laminate (III) composed of layer D', layer E, layer A and layer B, after which the interface between layer E and layer A is released to obtain a laminate (IV) composed of layer D' and layer E.

The thermal adhesive layer (C) comprising a fully aromatic polyamide having a glass transition temperature of 200-500°C preferably exists between the base material (A) and the inorganic material (B). The thermal adhesive layer (C) comprising a fully aromatic polyamide preferably has a constituent unit represented by the following formula (3-1).

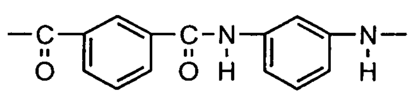

(3-1)

The base material (A) is preferably made of a polymer comprising a fully aromatic polyimide which has a constituent unit represented by the following formula (1):

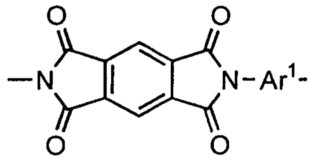

(1)

wherein $Ar^1$ is 1,4-phenylene which may optionally contain a non-reactive substituent.

Alternatively, the base material (A) is preferably made of a polymer comprising a fully aromatic polyimide which has 30-70 mole percent of a constituent unit represented by formula (1) above and 70-30 mole percent of a constituent unit represented by the following formula (2):

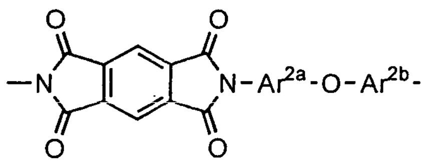

(2)

wherein $Ar^{2a}$ and $Ar^{2b}$ are each independently a C6-20 aromatic group optionally containing a non-reactive substituent.

The method of laminating the laminate (III) is not particularly restricted, and it may be obtained by the same method as described for the aforementioned laminated bodies (II) and (II').

A preferred application of the production process for a laminate according to the invention is one wherein the to-be-treated layer (D) is a semiconductor board subjected to circuit part formation steps including introduction of impurities and the inorganic material (B) is a holding substrate, the exposed surface of layer D is subjected to processing treatment whereby it is polished for thinning to form a thinned semiconductor board (layer D'), after which the interface between the organic protective layer (E) and the base material (A) is released to obtain a laminate for a semiconductor part composed of the semiconductor board (layer D') and the organic protective layer (E). The thermal adhesive layer (C) comprising a fully aromatic polyamide having a glass transition temperature of 200-500°C preferably exists between the base material (A) and the inorganic material (B).

(Method of releasing interface between layer E and layer A)

The following 4 methods may be mentioned as preferred methods of releasing the interface between layer E and layer A, when the laminate (III) is obtained and then the interface between layer E and layer A is released to obtain a laminate (IV) composed of layer D' and layer E.

The first method for releasing the interface between layer E and layer A is a method of immersing the laminate composed of layer D', layer E, layer A (preferably also layer C) and layer B in a liquid to allow the liquid to penetrate the interface between layer E and layer A, and then rapidly heating to above the boiling point of the liquid to gasify the liquid penetrated at the interface (Method 1). The immersion conditions in the liquid are preferably 30°C or above, and more preferably 40°C or above and no higher than the boiling point of the liquid. If the temperature is below 30°C, the liquid will not easily penetrate between the layers, thereby hampering release.

The immersion time is preferably 1 minute or longer, and more preferably 30 minutes or longer. The time is preferably not shorter than 1 minute because the penetration will not be promoted and release will be hampered.

An alternative method is cooling of the laminate after exposing it to vapor of the liquid for condensation of the liquid between the layers.

The conditions for heating after immersion are preferably at or above the boiling point of the liquid. More preferably, the temperature is 50°C or more above the boiling point of the liquid. The heating time is preferably within 5 minutes for increase to the prescribed temperature, and is more preferably within 30 seconds. With a time of longer than 5 minutes, it is difficult to obtain an effect of volume expansion by gasification, thereby hampering release.

The liquid may be one with a boiling point of 30°C or higher at ordinary pressure, and preferably it is a liquid with a boiling point of between 40°C and 200°C. As specific liquids there may be mentioned water, methanol, ethanol, 1-propanol, 2-propanol, 1-butanol, 2-butanol, tert-butanol, 1-pentanol, 2-pentanol, acetone, methyl ethyl ketone, diethylketone, cyclohexanone, cyclohexanol, 1,4-dioxane, hexane, heptane, octane, nonane, decane, benzene, toluene, o-xylene, m-xylene, p-xylene, aniline, pyridine, ethyl acetate, chloroform, dichloromethane, carbon tetrachloride and the like. Water, methanol, ethanol and isopropanol are preferred, and water is especially preferred.

The second method for releasing the interface between layer E and layer A is a method of immersing the laminate composed of layer D', layer E, layer A (preferably also layer C) and layer B in water to allow the water to penetrate the interface between layer E and Layer A, and then cooling to 0°C or below to solidify the water penetrated at the interface for release (Method 2). The immersion conditions in the water are preferably 30°C or above, and more preferably between 40°C and 100°C. If the temperature is below 30°C, the water will not easily penetrate between the layers, thereby hampering release.

The immersion time is preferably 1 minute or longer, and more preferably 5 minutes or longer. The time is preferably not shorter than 1 minute because the penetration will not be promoted and release will be hampered.

An alternative method is cooling of the laminate after exposing it to water vapor for condensation of the liquid between the layers.

The cooling conditions are preferably 0°C or below, and more preferably -5°C or below. The cooling time is preferably such as to accomplish cooling to the prescribed temperature within 10 minutes, and more preferably within 30 seconds. With a time of longer than 10 minutes, it is difficult to obtain an effect of volume expansion by solidification, thereby hampering release.

The third method for releasing the interface between layer E and layer A is a method of generating a temperature difference of 30-800°C in the direction of thickness of the laminate composed of layer D', layer E, layer A (preferably also layer C) and layer B, to induce release of the interface between layer E and layer A (Method 3). The method of generating the temperature difference is not particularly restricted, and there may be mentioned a method of shifting the laminate from a low temperature condition to a high temperature condition or shifting it from a high temperature condition to a low temperature condition, or a method of generating a temperature difference between the inorganic layer B side and the treated layer D'. The condition for a method of shifting the laminate from a low temperature condition to a high temperature condition or from a high temperature condition to a low temperature condition may be, for example, room temperature conditions in air or a liquid, or heated conditions by hot air heating, steam heating, vacuum heating, infrared heating or microwave heating, or by contact heating using a hot plate, hot roll, water bath, oil bath, TEG bath, salt bath, solder bath or the like, or cooled conditions using cooling air, dry ice, ice, cooling liquid or the like, for generation of a temperature difference between the conditions.

The method for generating a temperature difference in the direction of thickness of the laminate may be any method which produces different conditions on the respective sides. As preferred methods there may be mentioned contact with dry ice, ice or cooling liquid from above the laminate situated on a hot plate.

The temperature difference is 30-800°C but is preferably 100-600°C.

The fourth method for releasing the interface between layer E and layer A is a method of immersing the laminate composed of layer D', layer E, layer A (preferably also layer C) and layer B in an alkali solution with a pH of 8-14 to allow the alkali solution to penetrate layer A to induce release of the interface between layer E and layer A (Method 4). The alkali solution more preferably has a pH of 10-14, and is even more preferably an aqueous solution containing ammonia at a concentration of 0.1-30%. The solvent used for the alkali solution is not particularly restricted so long as it is a solvent which can dissolve the alkali, but it is preferably water. The immersion conditions are preferably a temperature of -5°C to 120°C, because at below -5°C the water in the aqueous solution will freeze and at above 120°C the water in the aqueous solution will boil. The immersion time is preferably 1-36,000 seconds, because with a time of shorter than 1 second the penetration into the film section will be inadequate, thereby hampering release, while a time of longer than 36,000 seconds will lengthen the process time and reduce productivity.

Using this manner of release method will not only yield a laminate composed of layer D' and layer E at high productivity, but will also facilitate recovery of layer A (preferably also layer C) and layer B for reuse after release.

## Examples

The process of the invention will now be explained in greater detail by examples, with the understanding that the scope of the invention is not limited in any way by these examples. The measurement methods for the properties of the invention and the evaluation methods for the effects were conducted as follows.

(1) Measurement of film Young's modulus

This was measured with an Orientech UCT-1T, using a 50 mm x 10 mm sample at a pull speed of 5 mm/min. The Young's modulus was determined from the stress (GPa) at 100% elongation based on the initial gradient of the elongation-stress curve for the measured data.

(2) Measurement of film linear thermal expansion coefficient

This was measured with a TA Instruments TMA 2940 Thermomechanical Analyzer, using an approximately

13 mm ($L_0$) x 4 mm sample, with heating at an elevation rate of 10°C/min in a range of 50-250°C, followed by cooling. The change in sample length ($\Delta L$) was measured from 100°C to 200°C, the thermal expansion coefficient of the film was determined by the following formula (5):

$$\text{Linear thermal expansion coefficient (ppm/°C)} = (1\text{ million x } \Delta L/L_0)/100 \quad (5)$$

and the average of the values in the perpendicular axial directions was calculated.

(3) Measurement of peel strength

After first cutting the adhesive body to a width of 10 mm and then thermocompression bonding it with the adherend at 5.0-6.0 MPa for 15 minutes, at 300°C in Example 3 and at 370°C in Examples 1, 2 and 4 and Example 17, clamp anchoring this with a jig, clamp anchoring an end of the adhesive sheet with another jig, and performing measurement with an Orientech UCT-1T at a pull speed of 300 mm/min at 25°C. The average pull force (N) was determined from a force-clamp travel distance curve across a peel length of at least 100 mm, subtracting the initial 25 mm, calculating the value per 1 m width (N/m).

(4) Measurement of shear peel adhesive strength

After first cutting the adhesive body and adherend into 25 mm squares and laminating them together, they were thermocompression bonded for 2 minutes at 300°C, 5.5 MPa. The adhesive was coated onto the exposed surface of the laminate and then bonded to two 25 mm x 60 mm x 1 mm stainless steel plates sandwiching it on either side, after which a method based on JIS K6851 was used for measurement with an Orientech UCT-1T at a pull speed of 10 mm/min at 25°C. The shear peel adhesive strength per 1 $cm^2$ ($N/cm^2$) was calculated from the maximum value (N) for the peel stress.

(5) Measurement of viscoelasticity

This was measured with a Rheometrics RSA II at a frequency of 6.28 rad/s, using an approximately 22 mm x 10 mm sample with temperature increase in the range of 50-500°C. The glass transition temperature was calculated from the value of the dynamic loss tangent $\tan\delta$ which is calculated using the measured dynamic storage elastic modulus E' and dynamic loss elastic modulus E".

(6) Measurement of silicon wafer surface roughness

The surface roughness of a 1.2 mm x 0.92 mm center section of the silicon wafer was measured using an NT-2000 non-contact three-dimensional microsurface shape analyzer (WYKO) .

[Adhesive Sheet Production Example 1]

After placing 1920 g of dehydrated NMP in a reactor equipped with a thermometer, stirring device and starting material charging port under a nitrogen atmosphere, 26.52 g of p-phenylenediamine was added and thoroughly dissolved therein. The solution was then cooled in an ice bath and the temperature of the diamine solution was adjusted to 3°C. To the cooled diamine solution there was added 53.46 g of pyromellitic anhydride, and reaction was conducted for 1 hour. The temperature of the reaction solution at this time was 5-20°C. The reaction solution was then reacted at room temperature (23°C) for 3 hours, after which 0.091 g of phthalic anhydride was added, and reaction was conducted for 1 hour to close the amine terminals, in order to obtain a polyamic acid NMP solution as a viscous solution.

The obtained polyamic acid solution was cast onto a 1.0 mm-thick glass panel using a doctor plate and then immersed for 30 minutes in a 30°C dehydration/condensation bath comprising 250 ml of acetic anhydride, 74 g of triethylenediamine and 2000 ml of NMP for imidation/isoimidation, and separated from the glass plate support to obtain a gel film.

The obtained gel film was immersed in NMP at room temperature for 20 minutes for washing, and then both ends of the gel film were anchored with a chuck and subjected to simultaneous biaxial stretching in the perpendicular biaxial directions at a speed of 10 mm/sec at room temperature, to a factor of 1.05. The degree of swelling of the gel film was 1510% at the start of stretching. (The degree of swelling was calculated from the ratio of the weight in the swelled state and dried state. That is, it was calculated according to the following formula, where $W^1$ is the dry weight and $W^2$ is the swelled weight: Degree of swelling = $((W^2/W^1)-1) \times 100$.)

The stretched gel film was anchored to a frame, and the temperature was increased in multistages from 160°C to 300°C with a hot air drier employing dry air, for drying and heat treatment. A hot air circulating oven was then used for multistage temperature increase to 300-450°C to obtain an adhesive sheet made of a fully aromatic polyimide film. Thus, the adhesive sheet was an adhesive sheet composed of a fully aromatic polyimide film which has a constituent unit represented by the following formula (1-a).

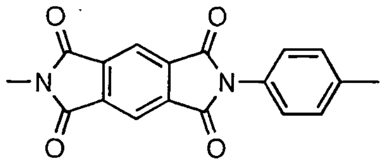

(1-a)

The adhesive sheet obtained in this manner will hereinafter be referred to as P-1. The film thickness, strength, Young's modulus, glass transition temperature and linear thermal expansion coefficient of P-1 are shown in Table 1.

[Adhesive Sheet Production Example 2]

After placing 2010 g of dehydrated NMP in a reactor equipped with a thermometer, stirring device and starting material charging port under a nitrogen atmosphere, 40.95 g of p-phenylenediamine and 91.77 g of 3,4'-diaminodiphenylether were added and thoroughly dissolved therein. The solution was then cooled in an ice bath and the temperature of the diamine solution was adjusted to 3°C. To the cooled diamine solution there was added 181.8 g of pyromellitic anhydride, and reaction was conducted for 1 hour. The temperature of the reaction solution at this time was 5-20°C. The reaction solution was then reacted at room temperature (23°C) for 8 hours, after which 0.247 g of phthalic anhydride was added and reaction was conducted for 1 hour to close the amine terminals, in order to obtain a polyamic acid NMP solution as a viscous solution. The concentration of the obtained polyamic acid NMP was 13 wt%.

The obtained 13 wt% polyamic acid solution was cast onto a 1.0 mm-thick glass panel using a doctor plate and then immersed for 30 minutes in a 30°C dehydration/condensation bath comprising 1050 ml of acetic anhydride, 450 ml of pyridine and 1500 ml of NMP for imidation/isoimidation, and separated from the glass plate support to obtain a gel film.

The obtained gel film was immersed in NMP at room temperature for 20 minutes for washing, and then both ends of the gel film were anchored with a chuck and subjected to simultaneous biaxial stretching in the perpendicular biaxial directions at a speed of 10 mm/sec at room temperature, at a stretch ratio of 3.1 times. The degree of swelling of the gel film was 394% at the start of stretching.

The stretched gel film was anchored to a frame, and the temperature was increased in multistages from 160°C to 300°C with a hot air drier employing dry air, for drying and heat treatment. A hot air circulating oven was then used for multistage temperature increase to 300-450°C to obtain a fully aromatic polyimide film.

Thus, the adhesive sheet was an adhesive sheet made of a fully aromatic polyimide film which has 50 mole percent of a constituent unit represented by the following formula (1-a).

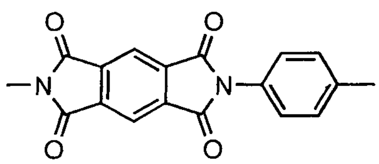

(1-a)

and 50 mole percent of a constituent unit represented by the following formula (2-a).

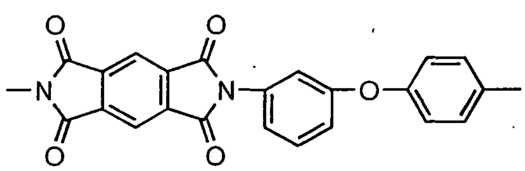

(2-a)

The adhesive sheet obtained in this manner will hereinafter be referred to as P-2.

The film thickness, strength, Young's modulus, glass transition temperature and linear thermal expansion coefficient of P-2 are shown in Table 1.

Table 1

| Adhesive sheet | Film thickness (µm) | Glass transition temperature (°C) | Young's modulus (GPa) | Linear thermal expansion coefficient (ppm/°C) |
|---|---|---|---|---|
| P-1 | 12 | >500 | 16.2 | -8.60 |
| P-2 | 20 | 410 | 10.4 | +5.75 |

Example 1

The fully aromatic polyimide film P-1 used as the adhesive sheet was placed firmly against a silicon wafer made of an inorganic material (6-inch diameter, 600 µm thickness, surface roughness (Rt): approximately 0.02 µm, linear thermal expansion coefficient: +4.15 ppm/°C) used as the adherend, and they were then sandwiched between metal plates and set in a hot press machine. After adjusting the surface temperature of the actual contact surface to 370°C with the hot press machine, pressing was carried out for 15 minutes at 5.5 MPa for bonding. The press heat was cut off to allow cooling to 250°C, and then the laminate was removed from the press machine. The peel strength at the interface between the obtained fully aromatic polyimide film P-1 and the silicon wafer was 15.0 N/m. The absolute value of the difference in the linear thermal expansion coefficients of the fully aromatic polyimide film P-1 and the silicon wafer was 12.75 ppm/°C.

Example 2

A laminate was obtained in the same manner as Example 1, except that the adhesive sheet used was the fully aromatic polyimide film P-2. As a result, the peel strength at the interface between the obtained fully aromatic polyimide film P-2 and the silicon wafer was 32.5 N/m. The absolute value of the difference in the linear thermal expansion coefficients of the fully aromatic polyimide film P-2 and the silicon wafer was 1.60 ppm/°C.

Example 3

After dispersing powder of Cornex$^R$ by Teijin Techno Products Co., Ltd. in N-methyl-2-pyrrolidone at 5°C, it was dissolved therein at 40°C to obtain a 10 wt% solution. A bar coater with a thickness of 28 µm was used to cast the 10 wt% Cornex$^R$ solution onto the fully aromatic polyimide film P-1 attached to a glass panel. Next, drying at 160°C for 30 minutes with a hot air drier was followed by multistage temperature increase to 280°C for drying and heat treatment to obtain an adhesive sheet made of a fully aromatic polyamide film and having a thermal adhesive layer (C).

The thermal adhesive layer (C) side of the adhesive sheet was placed firmly against a silicon wafer made of an inorganic material (6-inch diameter, 600 µm thickness, surface roughness (Rt): approximately 0.02 µm) used as the adherend, and they were then sandwiched between metal plates and set in a hot press machine. After adjusting the surface temperature of the actual contact surface to 300°C with the hot press machine, pressing was carried out for 2 minutes at 5.5 MPa for bonding. The press heat was then cut off to allow cooling. The peel strength at the interface between the thermal adhesive layer (C) and the silicon wafer of the obtained laminate was 200 N/m, and the shear peel adhesive strength was 170 N/cm$^2$.

Example 4

An adhesive sheet made of a fully aromatic polyamide film and having a thermal adhesive layer (C) was obtained in the same manner as Example 3, except that the fully aromatic polyimide film P-1 used was the fully aromatic polyimide film: Kapton$^R$ 50H by Toray-DuPont, and the thermal bonding temperature was 370°C.

The thermal adhesive layer (C) side of the adhesive sheet was placed firmly against a silicon wafer made of an inorganic material (6-inch diameter, 600 µm thickness, surface roughness (Rt): approximately 0.02 µm) used as the adherend, and they were then sandwiched between metal plates and set in a hot press machine. After adjusting the surface temperature of the actual contact surface to 300°C with the hot press machine, pressing was carried out for 2 minutes at 5.5 MPa for bonding. The press heat was then cut off to allow cooling. The peel strength at the interface between the thermal adhesive layer (C) and the silicon wafer of the obtained laminate was 200 N/m.

Example 5

On one side of a fully aromatic polyimide film P-1 having the same laminated construction as in Example 3 there were further situated a polyimide coat layer as an organic protective layer (E) and a silicon wafer with a thickness of 0.6 mm and a diameter of 150 mm, and the laminate was set in a hot press for pressing at 5 MPa, 300°C for 2 minutes. That is, a silicon wafer (holding substrate), Cornex$^R$ layer, fully aromatic polyimide film P-1, organic protective layer (E) and silicon wafer (semiconductor board) were laminated in that order.

The exposed side of the silicon wafer (semiconductor board) of the laminate was set on a polishing machine and polishing paper containing silicon carbide particles was used with rotation of the polishing plate at 110 rpm under a load of 160 gf/cm$^2$ for polishing to a silicon wafer thickness of 130 μm. The polishing was carried out using particle sizes in the order of #150, #800, #2000. No peeling of the laminate was observed during the polishing.

The obtained laminate was immersed in 60°C water for 1 hour and then removed. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 6

A polished laminate prepared in the same manner as Example 5 was immersed in 100°C water for 1 minute. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 7

A polished laminate prepared in the same manner as Example 5 was exposed to water vapor at 3 kgf/cm$^2$ for 1 minute. Subsequently, it was immediately immersed in 20°C water for 3 seconds and removed. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 8

A polished laminate prepared in the same manner as Example 5 was immersed in 30°C methanol for 1 hour. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 9

A polished laminate prepared in the same manner as Example 5 was immersed in 50°C ethanol for 1 hour. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 10

A polished laminate prepared in the same manner as Example 5 was immersed in 80°,C isopropanol for 1 hour. It was then set on a hot plate at 200°C for 30 seconds and then removed off and restored to room temperature.

The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 11

A polished laminate prepared in the same manner as Example 5 was immersed in 60°C water for 1 hour, and removed. It was then set in liquid nitrogen for 30 seconds and then removed off and restored to room temperature.
The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 12

A polished laminate prepared in the same manner as Example 5 was immersed in 100°C water for 1 minute. It was then set in liquid nitrogen for 30 seconds and then removed off and restored to room temperature.
The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 13

A polished laminate prepared in the same manner as Example 5 was exposed to water vapor at 3 kgf/cm$^2$ for 1 minute. Subsequently, it was immediately immersed in 20°C water for 3 seconds and removed. It was then set in liquid nitrogen for 30 seconds and then removed off and restored to room temperature.
The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 14

A polished laminate prepared in the same manner as Example 5 was placed on a hot plate at 300°C with the holding substrate side facing downward, and then ice was placed on the silicon wafer (semiconductor board) side for cooling.
The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 15

A polished laminate prepared in the same manner as Example 5 was placed on a hot plate at 400°C with the holding substrate side facing downward, and then liquid nitrogen was cast onto the silicon wafer (semiconductor board) side for cooling.
The laminate easily released at the interface between the polyimide coat layer and the aromatic polyimide film P-1. No release occurred at the interfaces between the silicon wafer (holding substrate), Cornex$^R$ layer and aromatic polyimide film P-1.

Example 16

A polished laminate prepared in the same manner as Example 5 was immersed in a 25% ammonia aqueous solution at room temperature. Upon confirming release of the laminate after 3 hours, it was removed.
The laminate released at the interface between the polyimide coat layer and the aromatic polyimide film P-1, and the aromatic polyimide film had completely dissolved. The interface between the holding substrate and the aromatic polyimide layer also released.

Example 17

A silicon wafer (holding substrate), a fully aromatic polyimide film P-2, a polyimide coat layer and a silicon wafer with a thickness of 0.6 mm and a diameter of 150 mm (semiconductor board) were laminated in that order, and the laminate was set in a hot press for pressing at 5.5 MPa, 370°C for 15 minutes. That is, a silicon wafer (holding substrate), fully aromatic polyimide film P-2, polyimide coat layer and silicon wafer (semiconductor board) were laminated in that order.

The exposed side of the silicon wafer (semiconductor board) of the laminate was set on a polishing machine and polishing paper containing silicon carbide particles was used with rotation of the polishing plate at 110 rpm under a load of 160 gf/cm$^2$ for polishing to a silicon wafer thickness of 130 µm. The polishing was carried out using particle sizes in the order of #150, #800, #2000. No peeling of the laminate was observed during the polishing.
The polished laminate was immersed in a 2.5% ammonia aqueous solution at room temperature. Upon confirming release of the laminate after 3 hours, it was removed.
The aromatic polyimide film P-2 of the laminate had completely dissolved, and release occurred at the interface between the polyimide coat layer and the aromatic polyimide film P-2.

## Claims

1. An adhesive sheet composed of a base material (A) comprising a fully aromatic polyimide film having a glass transition temperature of 200°C or above and a thermal adhesive layer (C) comprising a fully aromatic polyamide having a glass transition temperature of 200-500°C, the adhesive sheet being **characterized in that**, when the thermal adhesive layer (C) and base material (A) are laminated **in that** order on a silicon wafer adherend, either or both of the following conditions (a) and (b) are satisfied.

   (a) A peel strength of 0.1-300 N/m at the interface between the thermal adhesive layer (C) and silicon wafer upon thermocompression bonding for 15 minutes at 300°C, 5.0-6.0 MPa.
   (b) A shear peel adhesive strength of 1-1000 N/cm$^2$ at the interface between the thermal adhesive layer (C) and silicon wafer upon thermocompression bonding for 2 minutes at 300°C, 5.0-6.0 MPa.

2. An adhesive sheet according to claim 1, **characterized in that** the linear thermal expansion coefficient is in the range of -10 ppm/°C to +45 ppm/°C.

3. An adhesive sheet according to claim 1, **characterized in that** the Young's modulus is in the range of 1.0-30 GPa.

4. An adhesive sheet according to claim 1, **characterized in that** the base material (A) comprises a fully aromatic polyimide which has a constituent unit represented by the following formula (1):

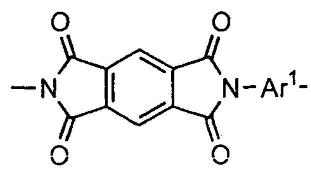

(1)

   wherein Ar$^1$ is 1,4-phenylene which may optionally contain a non-reactive substituent.

5. An adhesive sheet according to claim 1, **characterized in that** the base material (A) comprises a fully aromatic polyimide which has 30-70 mole percent of a constituent unit represented by the following formula (1):

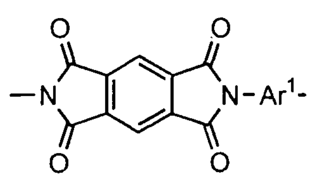

(1)

   and 70-30 mole percent of a constituent unit represented by the following formula (2):

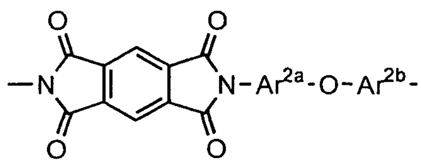

(2)

wherein $Ar^{2a}$ and $Ar^{2b}$ are each independently a C6-20 aromatic group optionally containing a non-reactive substituent.

6. An adhesive sheet according to claim 1, **characterized in that** the adhesive sheet comprises a fully aromatic polyimide with an imide group density (eq./kg) of between 5.5 eq./kg and 6.9 eq./kg, according to the following formula (4).

$$\text{Imide group density (eq./kg)} = 2 \times 1000/[\text{molecular weight per constituent unit}] \quad (4)$$

7. An adhesive sheet according to claim 1, **characterized in that** the thermal adhesive layer (C) comprises a fully aromatic polyamide which has a constituent unit represented by the following formula (3):

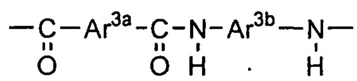

(3)

wherein $Ar^{3a}$ and $Ar^{3b}$ are each independently a C6-20 aromatic group optionally containing a non-reactive substituent.

8. An adhesive sheet according to claim 1, **characterized in that** the thermal adhesive layer (C) comprises a fully aromatic polyamide which has a constituent unit represented by the following formula (3-1).

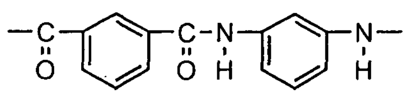

(3-1)

9. An adhesive sheet according to claim 1, **characterized in that** the adhesive sheet is used for anchoring of a semiconductor in a semiconductor device fabrication process.

10. A laminate (I) having an inorganic material (B) further laminated on the thermal adhesive layer (C) of an adhesive sheet according to claim 1, and therefore being composed of a base material (A) comprising a fully aromatic polyimide film, the thermal adhesive layer (C) and the inorganic material (B) laminated in that order.

11. The laminate (I) according to claim 10, **characterized in that** the inorganic material (B) is a silicon wafer.

12. The laminate (I) according to claim 10, **characterized in that** the laminate is used for anchoring of a semiconductor in a semiconductor device fabrication process.

13. A process for production of the laminate (I) according to claim 10, **characterized in that** the base material (A) comprising a fully aromatic polyimide film is thermocompression bonded with the inorganic material (B) via the thermal adhesive layer (C) comprising a fully aromatic polyamide having a glass transition temperature of 200-500°C, at a temperature of 180-600°C and a pressure of 0.001-1000 MPa for a period from 0.1 second to 1 hour.

14. A laminate (II) composed of an organic protective layer (E) and a to-be-treated layer (D) further laminated on the base material (A) of the laminate (I) according to claim 10, and thus beingcomposed of a to-be-treated layer (D), an organic protective layer (E), a base material (A) comprising a fully aromatic polyimide film, a thermal adhesive

layer (C) and an inorganic material (B), laminated in that order.

**15.** The laminate (II) according to claim 14,
**characterized in that** the to-be-treated layer (D) is a semiconductor board subjected to circuit part formation steps including introduction of impurities, and the inorganic material (B) is a holding substrate.

**16.** A process for production of the laminate (II) according to claim 14, **characterized in that** the to-be-treated layer (D), organic protective layer (E), base material (A), thermal adhesive layer (C) and inorganic material (B) are laminated **in that** order and thermocompression bonded at a temperature of 180-600°C and a pressure of 0.001-1000 MPa for a period from 0.1 second to 1 hour.

**17.** A laminate (I') which is composed of a base material (A) comprising a fully aromatic polyimide film with a glass transition temperature of 200°C or above and an inorganic material (B), **characterized in that** when the base material (A) and a silicon wafer adherend are laminated, the base material (A) exhibits the following property:

(a') A peel strength of 0.1-100 N/m at the interface between the base material (A) and silicon wafer upon thermocompression bonding for 15 minutes at 370°C, 5.0-6.0 MPa.

**18.** The laminate (I') according to claim 17,
**characterized in that** the base material (A) comprises of a fully aromatic polyimide which has a constituent unit represented by the following formula (1):

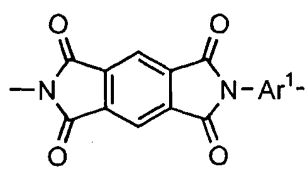

(1)

wherein $Ar^1$ is 1,4-phenylene which may optionally contain a non-reactive substituent.

**19.** The laminate (I') according to claim 18,
**characterized in that** the base material (A) comprises a fully aromatic polyimide which has 30-70 mole percent of a constituent unit represented by formula (1) above and 70-30 mole percent of a constituent unit represented by the following formula (2):

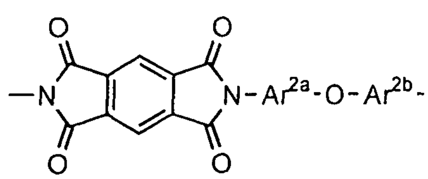

(2)

wherein $Ar^{2a}$ and $Ar^{2b}$ are each independently a C6-20 aromatic group optionally containing a non-reactive substituent.

**20.** The laminate (I') according to claim 17,
**characterized in that** the base material (A) comprises fully aromatic polyimide having an imide group density (eq./kg) of between 5.5 eq./kg and 6.9 eq./kg, calculated according to the following formula (4).

$$\text{Imide group density (eq./kg)} = 2 \times 1000/[\text{molecular weight per constituent unit}] \quad (4)$$

**21.** The laminate (I') according to claim 17,

**characterized in that** the inorganic material (B) is a silicon wafer.

**22.** The laminate (I') according to claim 17,
**characterized in that** the laminate is used for anchoring of a semiconductor in a semiconductor device fabrication process.

**23.** A process for production of the laminate (I') according to claim 17, **characterized in that** the base material (A) comprising a fully aromatic polyimide film and the inorganic material (B) are thermocompression bonded at a temperature of 180-600°C and a pressure of 0.001-1000 MPa for a period from 0.1 second to 48 hours.

**24.** A laminate (II') composed of an organic protective layer (E) and a to-be-treated layer (D) further laminated on the base material (A) of a laminate (I') according to claim 17, and thus being composed of a to-be-treated layer (D), an organic protective layer (E), a base material (A) comprising a fully aromatic polyimide film and an inorganic material (B), laminated in that order.

**25.** The laminate (II') according to claim 24,
**characterized in that** the to-be-treated layer (D) is a semiconductor board subjected to circuit part formation steps including introduction of impurities, and the inorganic material (B) is a holding substrate.

**26.** A process for production of the laminate (II') according to claim 24, **characterized in that** the to-be-treated layer (D), organic protective layer (E), base material (A) and inorganic material (B) are laminated **in that** order and thermocompression bonded at a temperature of 180-600°C and a pressure of 0.001-1000 MPa for a period from 0.1 second to 48 hours.

**27.** A process for production of a laminate (IV)
**characterized in that**, after laminating and thermocompression bonding a to-be-treated layer (D), an organic protective layer (E), a base material (A) comprising a fully aromatic polyimide film having a glass transition temperature of 200°C or above and an inorganic material (B) **in that** order, the exposed surface of layer D is subjected to thinning treatment to produce layer D' and obtain a laminate (III) composed of layer D', layer E, layer A and layer B, after which the interface between layer E and layer A is released to obtain a laminate (IV) composed of layer D' and layer E.

**28.** A process for production of a laminate (IV) according to claim 27, **characterized in that** the thermal adhesive layer (C) comprising a fully aromatic polyamide having a glass transition temperature of 200-500°C exists between the base material (A) and the inorganic material (B).

**29.** A process for production of a laminate (IV) according to claim 27 or 28, **characterized in that** the base material (A) comprises a fully aromatic polyimide which has a constituent unit represented by the following formula (1):

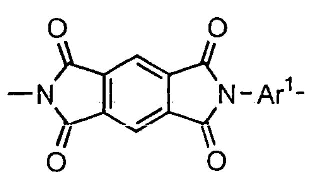

(1)

wherein $Ar^1$ is 1,4-phenylene which may optionally contain a non-reactive substituent.

**30.** A process for production of a laminate (IV) according to claim 27 or 28, **characterized in that** the base material (A) comprises a fully aromatic polyimide which has 30-70 mole percent of a constituent unit represented by formula (1) above and 70-30 mole percent of a constituent unit represented by the following formula (2):

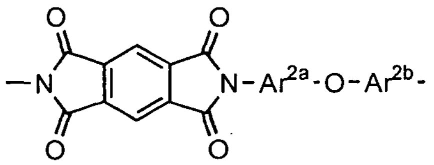

(2)

wherein $Ar^{2a}$ and $Ar^{2b}$ are each independently a C6-20 aromatic group optionally containing a non-reactive substituent.

**31.** A process for production of a laminate (IV) according to claim 28, **characterized in that** the thermal adhesive layer (C) has a constituent unit represented by the following formula (3-1).

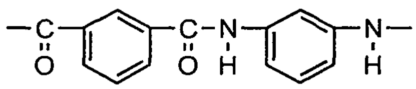

(3-1)

**32.** A process for production of a laminate (IV) according to claim 27 or 28, wherein the to-be-treated layer (D) is a semiconductor board subjected to circuit part formation steps including introduction of impurities and the inorganic material (B) is a holding substrate, and the exposed surface of layer D is subjected to processing treatment whereby it is polished for thinning to form a thinned semiconductor board (layer D'), after which the interface between the organic protective layer (E) and the base material (A) is released to obtain a laminate for a semiconductor part comprising the semiconductor board (layer D') and the organic protective layer (E).

**33.** A process for production of a laminate (IV) according to claim 27 or 28, **characterized in that** the method for releasing the interface between layer E and layer A is a method of immersing the laminate in a liquid to allow the liquid to penetrate the interface between layer E and layer A, and then rapidly heating to above the boiling point of the liquid to gasify the liquid penetrated at the interface.

**34.** A process for production of a laminate (IV) according to claim 27 or 28, **characterized in that** the method for releasing the interface between layer E and layer A is a method of immersing the laminate in water to allow the water to penetrate the interface between layer E and layer A, and then cooling to 0°C or below to solidify the water penetrated' at the interface for release.

**35.** A process for production of a laminate (IV) according to claim 27 or 28, **characterized in that** the method for releasing the interface between layer E and layer A is a method of generating a temperature difference of 30-800°C in the direction of thickness of the laminate to induce release of the interface between layer E and layer A.

**36.** A process for production of a laminate (IV) according to claim 27 or 28, **characterized in that** the method for releasing the interface between layer E and layer A is a method of immersing the laminate in an alkali solution with a pH of 8-14 to allow the alkali solution to penetrate layer A to induce release of the interface between layer E and layer A.

## INTERNATIONAL SEARCH REPORT

International application No.
PCT/JP2004/000757

A. CLASSIFICATION OF SUBJECT MATTER
Int.Cl[7] C09J7/02, H01L21/02

According to International Patent Classification (IPC) or to both national classification and IPC

B. FIELDS SEARCHED

Minimum documentation searched (classification system followed by classification symbols)
Int.Cl[7] C09J7/02, H01L21/02

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2002-256237 A (Hitachi Chemical Co., Ltd.), 11 September, 2002 (11.09.02), Claims; Par. Nos. [0026], [0034] (Family: none) | 1-36 |
| A | JP 2002-256238 A (Hitachi Chemical Co., Ltd.), 11 September, 2002 (11.09.02), Claims; Par. Nos. [0015], [0019] (Family: none) | 1-36 |
| A | JP 5-263049 A (Kaneka Corp.), 12 October, 1993 (12.10.93), Claims; Par. No. [0027] (Family: none) | 1-36 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 March, 2004 (16.03.04) | 30 March, 2004 (30.03.04) |
| Name and mailing address of the ISA/ Japanese Patent Office | Authorized officer |
| Facsimile No. | Telephone No. |

Form PCT/ISA/210 (second sheet) (July 1998)